# EUROPEAN PATENT APPLICATION

(11) **EP 4 017 227 A1**
(43) Date of publication of application: **22.06.2022**
(21) Application number: 21216087.3
(22) Date of filing: 20.12.2021
(51) Int. Cl.: H05K 1/18, H05K 3/40, H05K 1/11

(54) **ELECTRICAL ELEMENT, METHOD OF PREPARING AN ELECTRICAL ELEMENT FOR A SOLDERING STEP, AND DEVICE FOR PREPARING AN ELECTRICAL ELEMENT FOR A SOLDERING STEP**

(30) Priority: 18.12.2020 DE 102020134205
(71) Applicant: TE Connectivity Germany GmbH, 64625 Bensheim (DE)
(72) Inventor: BLUMENSCHEIN, Rudi, 73499 Woert (DE); DRESSEL, Andre Martin, 64625 Bensheim (DE); BRABETZ, Florian, 64625 Bensheim (DE); GRETH, David, 73499 Woert (DE)
(74) Representative: Grünecker Patent- und Rechtsanwälte PartG mbB

(57) **Abstract**

Shown is an electrical element (10), with two conducting elements (11) that are spaced from each other, and that are exposed at least partially by forming a recess (20) for receiving an electrical component (40), where in in the recess (20), a trough (30) for the electrical component (40) is formed and the trough (30) stretches from the one conducting element (11) to the other conducting element (11). Further shown is a method for preparing an electrical element (10) for a soldering step, in which a component (40) is soldered onto two conducting elements (11) of the electrical elements (10) that lie exposed in a recess (20) wherein in the recess (20) a trough (30) for the component (40) is formed into the element (10). Further, a corresponding device (90) for preparing an electrical element (10) for a soldering step is shown.

## Description

The invention relates to an electrical element, with two conducting elements that are spaced from each other and that are exposed partially by forming a recess for receiving an electrical component.

Furthermore, the invention relates to a method for preparing an electrical element for a soldering step, in which a component is soldered onto two conducting elements of the electrical element that lie exposed in a recess.

Furthermore, the invention relates to a device for preparing an electrical element for a soldering step in which a component is soldered onto two conducting elements of the electrical elements that lie exposed in a recess.

The electrical element can be, for example, a ribbon cable as used for monitoring battery cells in electrically powered vehicles. In this context, a temperature-sensitive electrical component is often arranged between the two conducting elements in order to monitor the temperature. Typically, the component is inserted into the receptacle and soldered. A disadvantage in the prior art is that the electrical component sometimes moves in further production steps, resulting in either a defective soldering or the soldering is correct but is classified as defective by a downstream control system.

The object of the invention is to provide a solution in which the number of defective products is reduced.

According to the invention, this problem is solved for the electrical element introductorily mentioned in that a trough for the electrical element is formed in the recess and the trough stretches from one conducting element to the other conducting element.

For the method introductorily mentioned, this problem is solved by forming a trough in the recess for the component in the element.

For the device introductorily mentioned for preparing an electrical element, the problem is solved by a trough-forming device which is adapted to form a trough for the electrical component into the electrical element.

The formed trough positions and holds the electrical component during further production steps, in particular during a soldering step. This prevents the component from slipping in subsequent method steps so that it can always be fixed in the correct position, for example soldered, glued, crimped or welded. This makes it possible to reduce the number of defective products.

The solution according to the invention can be further improved by the following further developments and configurations, each of which is preferred and can be combined with one another.

It is advantageous if the conducting elements are parts of the trough, at least partially. This makes it possible to hold the electrical component in the recess in a position in which it contacts the contact elements.

The trough can extend onto the conducting elements and/or extend over the conducting elements. This also allows easy contacting of the conducting elements by the electrical component.

In a variant that is easy to implement, the trough can be formed by plastic deformation. For example, it can be plastically formed in the recess, in particular into the base of the recess.

Preferably, plastic deformation involves cold forming, i.e. deformation in which no temperature change, in particular no melting or heating, is necessary or occurs as a result of the deformation itself. Such a method can be carried out without much effort. In particular, cold forming can involve pressure forming, indenting, or sinking.

In a configuration alternative to cold forming, plastic deformation can take place at least partially in a warm state, i.e. at elevated temperatures, in particular at temperatures higher than the intended service temperature of the element and/or higher than a room temperature. Plastic deformation at such temperatures may be easier to carry out. In addition, plastic deformation at elevated temperatures can avoid stresses in the element.

In a further preferred configuration, the step of forming may alternatively or additionally comprise removing material, for example by etching, cutting or grinding. In this context, material may be removed from the element, such as the conducting elements and/or a carrier, in order to form in the trough.

The electrical element may have a carrier on which the conducting elements are located. The conducting elements can be arranged between the carrier and a layer arranged thereon. The carrier and the layer may be made of an electrically non-conducting material. The conducting elements may be embedded in the element between the carrier and the layer, which protects the conducting elements.

According to a preferred configuration, the conducting elements are elongated, band-shaped and/or strip-shaped. This enables easy and targeted conduction of the current with a compact element.

In another compact configuration, the conducting elements run parallel to each other.

The electrical element can have several conducting elements running parallel to each other, between which a trough is located. Thus, different pairs of conducting elements can be connected by respective different troughs.

It is particularly preferable, if the trough occupies only part of the area of the recess, since in this case, the recess cannot or does not have to assume a holding function for the electrical element. For example, the recess can have a cross-sectional area at least 50% larger than the trough. In this case, the cross-section is parallel to a plane of the surface of the element or the carrier. A value of max. 500 % can be regarded as an upper limit.

The electrical element can be strip-shaped or plate-shaped. In particular, a strip-shaped or plate-shaped electrical element can be considered to have an extension in one spatial direction which is at most 20%, preferably 10%, especially 5% of the extension in one or two spatial directions perpendicular thereto.

In a preferred configuration, the electrical element may be a flat ribbon cable, also known as FFC (Flexible Flat Cable) or a portion of a flat ribbon cable.

In an alternative configuration, the electrical element may be a flexible printed circuit board, also known as an FPC (Flexible Printed Circuit), or it may be a rigid printed circuit board (PCB, Printed Circuit Board).

In order to achieve a good holding and protection effect, the trough may have a base, preferably a continuous base and/or a flat base. The base may be parallel to the rest of the surface of the electrical element to allow easy and safer holding. Further, the trough may have side walls.

In a further preferred configuration, the trough is V-shaped in at least one cross section. This allows easy insertion and subsequent automatic adjustment of the electrical element. The trough can narrow along a direction perpendicular to a plane of the surface of the element or a plane of the element, in particular away from the recess. The trough may have a substantially planar base that is parallel to the plane of an upper surface of the electrical element and/or to the base of the recess. The trough may have opposing walls extending at an angle from the base to the recess. The angle of inclination of the walls may be between 80° and 20°.

The trough can be configured as a blind hole. This can simplify production. The trough can be open on one side, otherwise closed.

In order to save space, the trough can be recessed relative to the rest of the surface of the element.

The invention further comprises an arrangement comprising an electrical element according to the invention and an electrical component mounted in the trough and electrically connected to the conducting elements of the electrical element.

The trough can in part be approximately complementary to the electrical component in order to improve the holding effect. Preferably, the shape of the trough is complementary to a lower side of the component to be received lying in the trough. The electrical component can thus be held particularly securely and easily.

Likewise, to improve the holding effect, the trough can have a depth corresponding to at least 5%, preferably 10%, even more preferably 20%, especially 50% of the height of the electrical component. Depending on the application, a value of 20%, 30%, 50%, 80%, or 90% can be considered as the maximum value. The depth is measured perpendicular to the plane of the surface.

In a further preferred configuration, the trough may have a depth corresponding to at least 5%, preferably 10%, more preferably 20%, especially 50% of the height of the electrical element. Again, a value of 20%, 30%, 50%, 80%, or 90% can be considered as a maximum value. The higher the value, the more securely the electrical component is held. However, with higher values, the electrical element becomes mechanically weaker.

A ratio of depth to width and/or length of the trough may be at least 1:20. In preferred configurations, it may be at least 1:10, 1:3, or 1:2. A ratio of 1:5, 1:3, or 1:2 may be considered as a maximum value. The flatter the trough, the easier it is to form. However, with deeper troughs, the holding effect is higher.

In a preferred method, a tool, for example a punch, which at least partially corresponds to the shape of the component can be used for forming. In this way, a good fit of the trough to the electrical component can be automatically achieved. Such a tool, for example a punch or a die, may constitute part of the trough forming device.

In one embodiment that is easy to implement, the conducting elements can be deformed when the trough is formed.

In order to facilitate forming, a layer lying above the carrier can be partially removed before forming the trough. In particular, the removal can create the recess. The removal can be done by laser, for example. The layer may be connected to a carrier and/or a conducting element. At least one conducting element may be embedded in the element, in particular between the carrier and the layer.

The invention further comprises a method for attaching the component to the electrical element by soldering comprising a method for preparing an electrical element for a soldering step.

In a preferred configuration, solder is introduced into the receptacle after the trough has been formed, in particular in the form of a paste.

Furthermore, after forming the trough, the component can be inserted into the trough.

In a further step, the component can be soldered, in particular to at least one conducting element, after the trough has been formed. HF soldering is a particularly suitable soldering method.

The device according to the invention can be adapted for a method according to the invention. For this purpose, the device may comprise a forming mechanism, a laser ablation mechanism, a solder application mechanism, an insertion mechanism and/or a soldering mechanism. Furthermore, such a device may comprise gripping means for the electrical component and/or for the electrical component. Furthermore, feed mechanisms for the electrical element and/or for the electrical component may be provided. A device according to the invention can be adapted to form the trough by plastic deformation.

In the following, the invention is explained in more detail by means of preferred configurations with reference to the drawings. The preferred further developments and configurations shown are independent of each other and can be arbitrarily combined with each other, depending on how this is necessary in the application.

In the drawings:
- Fig. 1: shows a schematic, partially cut perspective view of an embodiment of an electrical element;
- Fig. 2: shows a schematic, partially cut perspective view of the embodiment of Fig. 1 together with an inserted electrical component;
- Fig. 3: shows a schematic side view of an embodiment of a device.

In the Figures, an electrical element 10 is shown in which two conducting elements 11 that are spaced from each other are partially exposed by forming a recess 20 for receiving an electrical component 40.

The electrical element 10 may be, for example, a ribbon cable 15 that is used to measure voltages in interconnected battery cells, such as those used in electric automobiles. An additional electrical component 40, such as a temperature-sensitive NTC (negative temperature coefficient) 41, can be arranged between two conducting elements 11 to monitor the temperature. Often, this component 40 is attached to the conducting elements 11 by soldering, particularly HF soldering (high frequency soldering). In previous methods, the electrical component 40 is inserted into the recess 20 in the desired position and orientation. However, during further processing, particularly during a soldering step, the position and orientation of the electrical component 40 may change undesirably. This can result in a defective component.

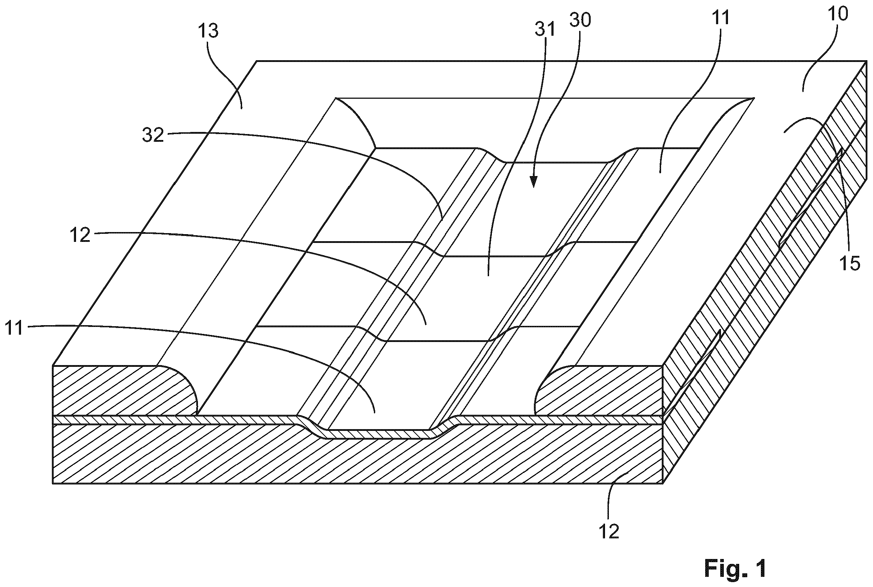

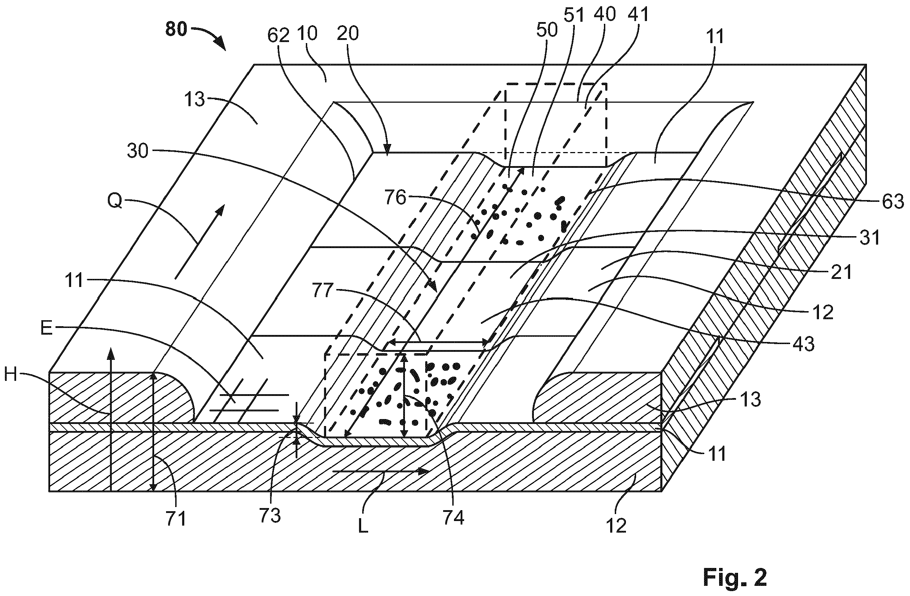

In order to prevent such a change in position and/or orientation, the embodiment of an electrical element 10 shown in Figures 1 and 2 comprises a trough 30 in the recess 20 that aligns the electrical component 40 and helps to maintain the alignment.

The trough 30 stretches from one conducting element 11 to the other conducting element 11. In the embodiment shown, the trough stretches to the conducting elements 11 and the conducting elements 11 are part of the side walls 32 and base 31 of the trough 30.

The trough 30 has been formed in by plastic deformation. For example, a tool in the form of a punch can be pressed against a height direction H into the base 21 of the recess 20. The tool can thereby permanently plastically deform the conducting elements 11 and a carrier 12 of the electrical element 10. The deformation may in particular be a cold deformation, for example a pressure deformation, indentation or sinking. Melting or heating is not necessary, however, it may have a positive effect on the result under certain circumstances.

In an alternative configuration, not shown, the forming of the trough 30 could also be carried out by removing material, for example, by etching, cutting, or grinding.

The conducting elements 11 are arranged between the carrier 12 and a layer 13 lying above it and embedded in the electrical element 10. The conducting elements 11 are strip-shaped or ribbon-shaped and run parallel to one another along a longitudinal direction L of the electrical element 10. The layer 13 is materially bonded to the carrier 12. A possible material for the carrier 12 and/or the layer 13 is PVC or another plastic.

The trough 30 occupies only a portion of the area of the recess 20. A cross-sectional area 62 of the recess 20 is substantially larger than a cross-sectional area 63 of the trough. The cross-sectional areas 62, 63 are each measured parallel to a plane E of the electrical element 10, in particular its surface. The plane E of the electrical element 10 is perpendicular to the height direction H and runs parallel to the longitudinal direction L and parallel to a transverse direction Q along which the conducting elements 11 are spaced from one another.

In the example shown, the trough 30 is approximately the same width as the recess 20 in the transverse direction Q. Along the longitudinal direction L, however, the trough 30 is only approximately one third as long as the recess 20. The recess 20 can therefore not achieve a holding function for the electrical component 40 along the longitudinal direction L. However, for processrelated reasons, it may be necessary for the recess 20 to be considerably longer along the longitudinal direction L than the component 40 to be received, for example in order to be able to clean the recess 20 easily or in order not to damage the layer 13 during a soldering process.

The electrical element 10 is strip-shaped or plate-shaped. In the height direction H, its extension is substantially smaller, for example by a maximum of 10 percent, than its extension in the transverse direction Q. Along the longitudinal direction L, the electrical element can again be substantially larger than along the transverse direction Q, for example by a factor of 5 to 10.

In addition to the flat ribbon cable 15 shown, a flexible or rigid printed circuit board (FPC) can be used as an electrical element 10.

The trough 30 is V-shaped or funnel-shaped. It narrows against the height direction H, thus, away from the recess 20. This allows automatic positioning and adjustment of the electrical component 40. Furthermore, such a configuration can be easy to manufacture.

The side walls 32 run at a slight angle to the height direction H and merge into the flat, continuous base 31. In this context, the base 31 is parallel to the plane E. The trough 30 is configured like a blind hole, thus, it is continuously closed in the area of the side walls 32 and the base 31 and only open on one side along the height direction H.

The trough 30 is recessed from the rest of the surface of the element 10.

The trough 30 has a depth 73 that is approximately 20 percent of the height 71 of the element 10 and 20 percent of the height 74 of the component 40. This allows good adjustment and support without at the same time interfering too much with the carrier 12.

A width 76 of the trough 30 measured along the transverse direction Q is substantially greater than its depth 73, for example by a factor of 20. A length 77 of the trough 30 measured along the longitudinal direction L is greater than its depth 73, for example by a factor of 10.

The recess 20 may be created, for example, by laser ablation of the layer 13. In alternative configurations, the indentation 20 may be created, for example, by cutting out or melting the layer 13.

Fig. 2 shows an arrangement 80 comprising the electrical element 10 and the electrical component 40 arranged therein. In order to achieve the best possible holding effect, a lower side 43 of the electrical component 40 is approximately complementary to the base 31 of the trough 30. This can be achieved, for example, by using a tool for forming the trough 30, the lower side of which is similar to the lower side 43 of the electrical component 40 to be inserted.

As shown in Fig. 2, the electrical component 40 can be electrically conductively connected to a conducting element 11 at one end in each case so that it electrically connects the two conducting elements 11. For this purpose, solder 50 may be present between the electrical component 40 and the conducting element 11 in each case. The solder 50 can be applied, for example, in the form of a paste 51 after the trough 30 has been formed in the area of the conducting elements 11. The electrical component 40 can then be inserted. By soldering, for example HF soldering, the electrical component 40 can then be joined to the respective conducting element 11.

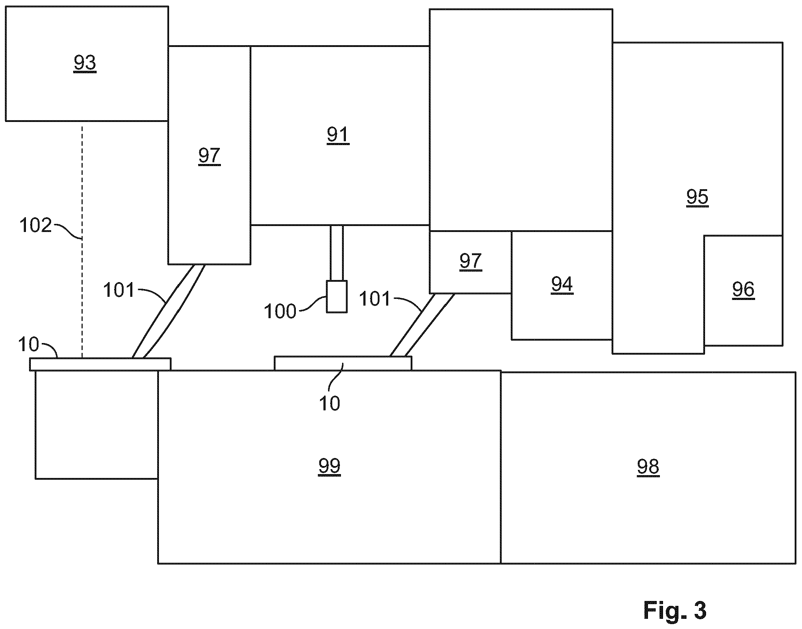

The method according to the invention can be carried out with a device 90 according to the invention. A possible configuration of such a device 90 is shown schematically in Fig. 3.

The device 90 comprises a trough forming device 91 configured to form a trough 30 for the electrical component 40 into the electrical element 10. The trough forming device 91 is configured as a forming mechanism 92, which at least partially plastically forms the element 10. For this purpose, it has a tool in the form of a punch 100 which can be moved towards and into the element 10. In order to have a stable counter-support during forming, the electrical element 10 is supported on a table 99 during this step.

In order to move the electrical element 10 onto and away from the table 99, gripping means 97 with pivotable gripping arms 101 are provided.

Prior to forming the trough 30, a laser ablation mechanism 93 is used to create the indentation 20 in the element 10 by removing the layer 13 with a laser beam 102.

After the trough 30 has been formed and repositioned by the gripping means 97, solder 50 in the form of a paste 51 is introduced into the trough 30 by means of a solder application mechanism 94.

The element 10 is then transported by a feed mechanism 98, which may comprise a conveyor belt, to an insertion mechanism 95. The component 40 is inserted there.

Finally, a soldering mechanism 96 is used to solder the component 40 to the conducting elements 11, preferably by HF soldering.

### Reference signs

- 10: electrical element
- 11: conducting element
- 12: carrier
- 13: layer
- 15: flat ribbon cable
- 20: recess
- 21: base
- 30: trough
- 31: base
- 32: side wall
- 40: electrical component
- 41: NTC
- 43: lower side
- 50: solder
- 51: paste
- 62: cross-sectional area of the recess
- 63: cross-sectional area of the trough
- 71: height of the element
- 73: depth of the trough
- 74: height of the component
- 76: width of the trough
- 77: length of the trough
- 80: arrangement
- 90: device
- 91: trough forming device
- 92: forming mechanism
- 93: laser ablation mechanism
- 94: solder application mechanism
- 95: insertion mechanism
- 96: soldering mechanism
- 97: gripping means
- 98: feed mechanism
- 99: table
- 100: punch
- 101: gripping arm
- 102: laser beam
- E: plane
- H: height direction
- L: longitudinal direction
- Q: transverse direction

## Claims

1. Electrical element (10), with two conducting elements (11) that are spaced from one other, and that are exposed at least partially by forming a recess (20) for receiving an electrical component (40), where a trough (30) is formed in the recess (20) for the electrical component (40), and where the trough (40) stretches from the one conducting element (11) to the other conducting element (11).

2. Electrical element (10) according to claim 1, wherein the trough (30) is formed by plastic deformation.

3. The electrical element (10) according to one of claims 1 or 2, wherein the conducting elements (11) are arranged between a carrier (12) and a layer (13) arranged thereon.

4. Electrical element (10) according to one of claims 1 to 3, wherein the trough (30) occupies only a part of the area of the recess (20).

5. Electrical element (10) according to one of claims 1 to 4, wherein the electrical element (10) is strip-shaped or plate-shaped.

6. Electrical element (10) according to one of claims 1 to 5, wherein the electrical element (10) is a ribbon cable (15) or a part of a ribbon cable (15).

7. Arrangement (80) comprising an electrical element (10) according to one of claims 1 to 6, and an electrical component (40) attached in the trough (30) and electrically connected to the conducting elements (11) of the electrical element (10).

8. Arrangement (80) according to claim 7, wherein the shape of the trough (30) is complementary to a lower side (43) of the component (40) to be received, which is located in the trough (30).

9. Method for preparing an electrical element (10) for a soldering step, in which a component (40) is soldered to two conducting elements (11) of the electrical element (10) that lie exposed in a recess (20), wherein a trough (30) for the component (40) is formed in the element (10) in the recess (20).

10. Method according to claim 9, wherein the trough (30) is formed by plastic deformation.

11. Method according to claim 9 or 10, wherein for forming, a tool is used which corresponds at least partially to the shape of the component (40).

12. Method according to one of claims 9 to 11, wherein the conducting elements (11) are deformed during the forming of the trough (30).

13. Method according to one of claims 9 to 12, wherein a layer (13) lying above a carrier (12) is partially removed before the trough (30) is formed.

14. Method for attaching the component (40) to the electrical element (10) by soldering, comprising the method according to one of claims 9 to 13.

15. Device (90) for preparing an electrical element (10) for a soldering step in which an electrical component (40) is attached by soldering to conducting elements (11) of an electrical element (10), wherein the device comprises a trough forming device (91) which is adapted to form a trough (30) for the electrical component (40) in the electrical element (10).
